# EUROPEAN PATENT SPECIFICATION

(11) **EP 4 457 869 B1**
(45) Date of publication and mention of the grant of the patent: **12.08.2026**
(21) Application number: 22835300.9
(22) Date of filing: 09.12.2022
(51) Int. Cl.: H10F 19/85

(54) **SOLAR MODULE**
SOLARMODUL
MODULE SOLAIRE

(30) Priority: 29.12.2021 GB 202119061
(43) Date of publication of application: 06.11.2024
(73) Proprietor: REC Solar Pte. Ltd., Singapore 637312 (SG)
(72) Inventor: HENG, Fook Hai, Singapore 637312 (SG); SRIDHARA, Shankar Gauri, Singapore 637312 (SG)
(74) Representative: Mewburn Ellis LLP
(86) International application number: PCT/EP2022/085149
(87) International publication number: WO 2023/126147

(56) References cited:
- DE-U1- 202016 103 473
- US-A1- 2011 214 716
- US-A1- 2016 163 903
- "Photovoltaic (PV) module safety qualification - Part 1: Requirements for construction", IEC 61730-1:2016, IEC, 3, RUE DE VAREMB?, PO BOX 131, CH-1211 GENEVA 20, SWITZERLAND, 17 August 2016 (2016-08-17), pages 1 - 106, XP082000090

## Description

### FIELD OF THE INVENTION

The present invention relates to a solar module, and to a method of manufacturing a solar module.

### BACKGROUND

Solar modules for providing electrical energy from sunlight typically comprise an array of solar cells (also referred to herein as photovoltaic or PV cells). Typical solar module architecture includes a transparent front sheet (typically glass), an encapsulant layer surrounding the array of solar cells, a protective backsheet (sometimes also referred to as a 'backing sheet', or a 'backing layer'), and an aluminium perimeter frame. The primary purpose of the front sheet, encapsulant layer, backsheet and the perimeter frame are to protect the solar cells both physically (e.g. against mechanical impacts) and chemically (e.g. against moisture infiltration). Providing a suitable module architecture can increase the expected lifespan and efficiency of the solar cells, thereby reducing the average cost of the electrical energy produced by the solar module.

Conventionally, solar module backsheets have been manufactured from insulating materials such as polymers. Use of an insulating material for the backsheet has a number of advantages, in that it is easy to provide a suitable amount of insulation around the junction box of the module to meet international safety standards, such as those set out in IEC 61730-1:2016, "Solar (PV) module safety qualification - Part 1: Requirements for construction", which is herein incorporated by reference.

However, for some solar modules, in particular for relatively high-power modules such as heterojunction cell (HJT) products, polymeric backsheets do not provide suitable heat dissipation and/or moisture resistance. Accordingly, for some solar modules, including heterojunction cell (HJT) products, it is typical to use an aluminium backsheet. Use of an aluminium backsheet can provide improved heat dissipation and moisture resistance in comparison to polymeric backsheets.

Some backsheet arrangements are known in which metal layers and polymeric layers are used in combination. For example, WO2010/073735A1 discloses a back surface protective sheet for a solar cell module in which an electrically insulating base sheet is laminated on at least one surface of an aluminium-iron alloy sheet.

US 2008/053512A1 discloses a back sheet for solar modules that is a laminate comprising a front face side resin film, a barrier film and a back face side resin film in that order, wherein the front face side resin film comprises polyolefin as a principal component

DE 20 2016 103473 U1 proposes arrangements for a solar power module. In some arrangements, the solar module comprises a back plate which includes an internal metal film to reinforce the strength of the back plate.

US 2011/214716 A1 proposes arrangements for solar modules including electrically isolated moisture barriers. The electrically isolated moisture barrier may be a thin metallic sheet, e.g., an aluminum foil.

The present invention has been devised in light of the above considerations.

### SUMMARY OF THE INVENTION

The present inventors have realised that provision of a suitable laminate interlayer in a solar module can provide an improved architecture for a solar module which may ameliorate or obviate some known problems associated with existing solar module architectures.

Accordingly, in a first aspect, the present invention provides a solar module as set out in claim 1.

By providing a module having an insulating backsheet, and a laminate interlayer comprising an electrically insulating layer and a metallic barrier film interposed between the encapsulant surrounding the solar cells and the backsheet, with the laminate interlayer having a lateral extent less than the lateral extent of the backsheet, it is possible to provide a module having similar or improved reliability as compared with conventional modules having a pure aluminium backsheet (by providing a suitable reduction in permeation of ingressive gas and/or liquid molecules into the solar module, and by providing improved heat transfer away from the solar cells), but with reduced risk of static buildup and discharge between conductive parts of the module due to the lateral spacing provided between the laminate interlayer and other portions of the solar module. In comparison, in modules having an aluminum backsheet, a relatively high rate of short circuit may be observed between the junction box connector which includes electrical terminals of the module, and the backsheet. Increased risk of short circuit is a safety risk, and furthermore may lead to decreased energy yield of the module, leading to module scrappage. Another problem is that the aluminum backsheet tends to charge up at high voltages, due to the short distance between backsheet and the junction box. This can result in static discharge to the perimeter frame of the module at high voltages, which is undesirable.

A further advantage is that a module architecture as described above can reduce the need for provision of additional insulating material in certain portions of the module, and in particular obviate the need to isolate the backsheet itself from other portions of the module, which may result in a reduction the complexity and cost of manufacture of the solar module. In comparison, known aluminium or composite backsheets which incorporate one or more polymeric layers typically require suitable insulation to be provided between the metal layers and other electrically live or conductive portions of the solar module, such as the aluminium perimeter frame and/or the junction box, because the metal layers of the composite backsheet have the same lateral extent as other layers (including insulating layers) of the backsheet, where present. This can increase the complexity and cost of manufacture of solar modules incorporating such backsheets, due to additional components and processes involved to ensure adequate isolation of the metal-containing backsheet.

The term "laminate interlayer" is used herein to describe an interlayer having a laminated structure. That, is, an element comprising one or more layers of material laminated on one another. The one or more layers may be laminated on one another via physical and/or chemical bonds. In the present arrangement, the one or more layers comprises at least two different materials: an electrically insulating layer and a metallic barrier film. Further details relating to the structure and composition of the laminate interlayer are set out below.

It will be understood that when an element such as a film, sheet, or substrate is referred to as being "on", "adjacent" or "opposite" to an element, it can be "directly on", "directly adjacent" or "directly opposite" to that further element; alternatively, there may be one or more intervening elements present. In contrast, when an element is referred to as being "directly on", "directly adjacent" or "directly opposite" another element, there are no intervening elements present.

The solar module comprises a width, a length and a height (sometimes also referred to as a thickness). Typically, the height (or thickness) of a solar module is substantially less than its length and its width. The length and the width of the module may be substantially equal (for a square module) or may be different (for a rectangular module). The solar module has a front face (alternatively referred to as a front surface) and a back face (alternatively referred to as a back surface), wherein the front face side and the back face side are defined based on the typical orientation of the solar cells within the module in use. The solar cells have a front face and a back face. The terms "front" and "forward" are used herein to refer to a direction towards a light source (e.g. the sun) in use and orthogonal to a front face of the solar module, and the terms "back", "rear" and "rearwardly" are intended to refer to a direction that is opposite to the front/forward direction.

The term "lateral", e.g. in the context of a "lateral extent" is used herein to refer to a direction lying in a plane which is substantially orthogonal to a height direction of the solar module, and substantially parallel to upper and lower surfaces of the solar module. The term "lateral extent" therefore refers to an area in such a plane. As the laminate interlayer has a lateral extent less than the lateral extent of the backsheet, the laminate interlayer may have at least one edge which underlaps a respective edge of the backsheet in a lateral direction. In some arrangements, each edge of the laminate interlayer may underlap a respective edge of the backsheet in a lateral direction.

The terms "conductive" and "insulating" as used herein, are expressly intended to mean electrically conductive and electrically insulating, respectively. The meaning of these terms will be particularly apparent in view of the technical context of the disclosure, being that of photovoltaic solar modules.

Optional features will now be set out. These are applicable singly or in any combination with any aspect.

First, optional features relating to the configuration of the laminate interlayer, and the arrangement of said layer within the module will be discussed. Then, optional features relating to the overall architecture of the module will be discussed.

As the laminate comprises a metallic barrier film, which is a conductive element, in order to minimise the risk of of static buildup and discharge between conductive parts of the module, it may be preferable for a minimum predetermined creepage distance to be provided between the laminate interlayer and conductive elements of the module. Creepage distance is defined as here as per the definition provided in IEC 61730-1:2016. That is, the creepage distance is defined as the shortest distance along the surface of a solid insulating material between two conductive live parts or between conductive live parts and accessible parts (accessible here referring to parts which are accessible during normal use). Creepage distance is sometimes abbreviated as "cr". Preferably, a predetermined minimum creepage distance is provided between the metallic barrier film layer of the laminate interlayer, and between one or more conductive live parts or conductive accessible parts of the module.

A solar module typically contains many conductive live parts and/or accessible parts. For example, the solar module may comprise a frame, or one or more frame elements (discussed in further detail below, in the section relating to overall module architecture). Where the solar module comprises an electrically conductive frame, or frame member (e.g. a metallic frame or frame member), it is preferred that a first predetermined minimum creepage distance is provided between an edge of the laminate interlayer and the electrically conductive frame or frame member. The first predetermined minimum creepage distance may be provided between the edge of the metallic barrier film layer of the laminate interlayer and the electrically conductive frame or frame member, where the edges of the metallic barrier film layer and of the laminate interlayer are not aligned. However, in some arrangements, the solar module may not comprise an electrically conductive frame.

As will be discussed in greater detail below, in the section relating to overall module architecture, the one or more electrically conductive interconnect members provided for electrical connection of the one or more solar cells to the terminal of the module may extend through a horizontal plane in which the laminate interlayer lies. In this case, it is preferred that a second predetermined minimum creepage distance is provided between an edge of the laminate interlayer and the one or more electrically conductive interconnect members. The second predetermined minimum creepage distance may be provided between the edge of the metallic barrier film layer of the laminate interlayer and the one or more electrically conductive interconnect members, where the edges of the metallic barrier film layer and of the laminate interlayer are not aligned. However, in some arrangements, the one or more electrically conductive interconnect members may not extend through a horizontal plane in which the laminate interlayer lies.

Where required, the first and/or second predetermined minimum creepage distances may be selected based on Table 3 of IEC 61730-1:2016, taking the system voltage carried and the pollution degree into account, as shown in this table, which is herein incorporated by reference.

The pollution degree is a numeric classification characteristic of the expected pollution of the micro-environment. The pollution degree may be 1, 2 or 3, but is preferably 1. For parts enclosed or encapsulated to provide protection against ingress of dust and moisture, the pollution degree can be considered to be 1 if test requirements according to IEC 61730-2, including test sequence B.1, are met.

The system voltage is the operating voltage under operating conditions. For a single module this may be the voltage carried by that single module during use ('single module carry voltage'), or module V_{OC}. However, for enhanced safety, in systems where a plurality of modules will be connected as part of a single installation, the total system voltage of the entire installation including the plurality of modules may be considered for determination of one or both of the first or second predetermined creepage distance.

Accordingly, the first predetermined minimum creepage distance may be selected to be greater than or equal to the value given in Row 1(a) or Row 3 (these values being the same at all system voltages & pollution degrees) of Table 3 of IEC 61730-1:2016 for at least the single module voltage or V_{OC}, and the pollution degree of the module. For example, for a module having a voltage or V_{OC} of 100 V DC, and a pollution degree of 1, the first predetermined minimum creepage distance may be greater than or equal to 0.5 mm. For a module having a voltage or V_{OC} of 300 V DC, and a pollution degree of 1, the first predetermined minimum creepage distance may be greater than or equal to 1.4 mm. For a module having a voltage or V_{OC} of 1000 V DC, and a pollution degree of 1, the first predetermined minimum creepage distance may be greater than or equal to 6.4 mm.

Whilst this is the minimum preferred creepage distance, as discussed above, a greater creepage distance than required based on a single module voltage may be used. For example, as discussed above, where the module will be installed in a system incorporating multiple such modules, it may be preferable to consider the total system voltage of the entire installation including the plurality of modules. So, in one example, for a single module having a Voc of about 50 V and pollution degree of 1 (i.e. a required minimum creepage distance of only 0.5 mm based on Table 3 of IEC 61730-1:2016), to be installed in a system incorporating multiple such modules, where the total system voltage is 1000V, the first predetermined minimum creepage distance may be selected to be 6.4 mm or greater, in line with the value given in Table 3 for a system voltage of 1000V.

The second predetermined minimum creepage distance may be selected to be greater than or equal to the value given in Row 1(a) or Row 3 (these values being the same at all system voltages & pollution degrees) of Table 3 of IEC 61730-1:2016 for at least the single module system voltage or V_{OC}, and the pollution degree of the module. For example, for a module having a voltage or V_{OC} of 100 V DC, and a pollution degree of 1, the second predetermined minimum creepage distance may be greater than or equal to 0.5 mm. For a module having a voltage or V_{OC} of 300 V DC, and a pollution degree of 1, the second predetermined minimum creepage distance may be greater than or equal to 1.4 mm. For a module having a voltage or V_{OC} of 1000 V DC, and a pollution degree of 1, the second predetermined minimum creepage distance may be greater than or equal to 6.4 mm. Similarly to above, this is a minimum preferred creepage distance for the module, and for safety, a larger creepage distance may be selected (e.g. based on the total system voltage for a system incorporating a plurality of such modules).

As mentioned above, the laminate interlayer is interposed between the encapsulant and the backsheet. That is, the laminate interlayer is provided on a back face side of the solar cells. The laminate interlayer may substantially overlay all of the one or more solar cells on a back face side. In other words, the lateral extent of the laminate interlayer may be greater than the total lateral extent of the one or more solar cells. This can provide for improved reliability of the module, by allowing for suitable heat transfer away from each of the overlaid solar cells, and also by providing some protection to each of the overlaid solar cells to permeation of ingressive gas and/or liquid molecules.

The laminate interlayer comprises two or more non-contiguous regions. In other words, the laminate interlayer comprises two or more separate parts, each part comprising an electrically insulating layer and a metallic barrier film arranged in that order from a front face side of the module to the back face side of the module. It is preferred that said regions extend in substantially the same horizontal plane. It is preferred that said regions have the same structure. This may allow for improved ease of assembly of the module, as separate portions of the laminate interlayer can be arranged at the same time or in close succession during the manufacturing process. An arrangement according to the invention where the laminate interlayer comprises two or more non-contiguous regions provides specific advantages where the module comprises one or more conductive elements extending through the module in a central region of the module, as it can reduce the need for the laminate interlayer to be formed in a convoluted shape to avoid direct connection with such conductive elements. For example, where the module comprises one or more electrically conductive interconnect members which extend through a horizontal plane in which the laminate interlayer lies, the laminate interlayer may be arranged such that the one or more electrically conductive interconnect members extend through a gap between the non-contiguous regions of the interlayer. This can reduce the manufacturing complexity of the module.

As discussed above, the minimum structure of the laminate interlayer includes an electrically insulating layer and a metallic barrier film arranged in that order from a front face side of the module to the back face side of the module. Providing the insulating layer on the front face side of the laminate interlayer allows for a suitable thickness of insulation to be provided between the solar cells surrounded by encapsulant, and the metallic barrier film of the laminate interlayer.

The electrically insulating layer may have a thickness which is significantly smaller than its length and width. The electrically insulating layer may have a thickness which is selected based on based on Table 3 of IEC 61730-1:2016, specifically based on the requirements for layer thickness given in the row headed "Thickness of thin layers". The electrically insulating layer may therefore have a thickness of 0.01 mm or more. The electrically insulating layer may therefore have a thickness of 0.05 mm or less. For example, the thickness of the electrically insulating layer may be about 0.01 mm, about 0.02 mm, about 0.03 mm, about 0.04mm or about 0.05 mm. It may be advantageous for the electrically insulating layer to be as thin as possible whilst meeting the standards set out in IEC 61730-1:2016. Accordingly, the preferred thickness of the insulating layer is from 0.01 mm to 0.03 mm. The electrically insulating film thickness may be substantially uniform. The electrically insulating layer may be substantially planar.

The electrically insulating layer may be formed from a material having a relative thermal index (RTI) of greater than 90 °C. The RTI is the temperature in degrees C, at which the properties (e.g. electrical insulating performance) have decreased to 50 percent of their initial value after a long-term exposure to this temperature. Though the RTI is an index, it is typically given in Celsius units, although in the art, is sometimes also referred to as a unitless value. RTI is determined in accordance with IEC 60216-5 or IEC 60216-1.

If this electrically insulating layer is formed from a material having a suitable relative thermal index, it can meet the IEC standards to be included when calculating distance through insulation, creepage distances (cr) or clearances (cl) for Class II PV modules as defined in IEC 61730-1:2016. Specifically, materials used as relied upon insulation are required to have a minimum RTI in accordance with IEC 60216-5 or IEC 60216-1 equal to or greater than the maximum normalized operating temperature of the material as measured in the particular mounting situation (e.g. roof mounted) during the temperature test (MST 21), or 90 °C, whichever is higher. For open rack mounted PV modules, the normalized measured maximum PV module operating temperature can be assumed to be 90 °C, so the insulation is required to be at least 90 °C. Materials having an RTI of less than 90 °C will not meet the IEC standards to be included when calculating distance through insulation, creepage distances (cr) or clearances (cl) for Class II PV modules as defined in IEC 61730-1:2016.

The electrically insulating layer may therefore comprise a material selected from the group consisting of: polyethylene terephthalate (PET), polyolefins (PO), polyamides (PA), and polycarbonates (PC). Preferably the electrically insulating layer comprises PET, which has an RTI of 105 °C.

The metallic barrier film may be formed from any suitable metallic material. Preferably, the metallic barrier film is formed from aluminium, although the use of other metallic materials such as copper are also contemplated. The use of aluminium offers advantages such as high corrosion resistance, and low oxidation rate in air. Furthermore, aluminium has low density, which can assist in reducing overall weight of the module. It will be appreciated that the term 'film' refers to an element which defines a substantially thin layer, for example, a foil, or a thin strip of material. The barrier film may have a thickness which is significantly smaller than its length and width. In preferred arrangements, the metallic barrier film is formed from an aluminium foil. Aluminium foils are low density (therefore lightweight), cost effective, and easy to work with during manufacture.

The thickness of the metallic barrier film may be 0.005 mm or more (i.e. 5 µm or more), for example 0.006 mm or more, or 0.007 mm or more. The thickness of the metallic barrier film may be 0.011 mm or less, for example 0.010 mm or less, or 0.009 mm or less. Preferably, the thickness of the metallic barrier film is in a range from 0.007 mm to 0.009 mm. The precise thickness of metallic barrier film used may depend on manufacturer capability and material cost.

The barrier film thickness may be substantially uniform. The barrier film may be substantially planar.

The barrier film may be configured to be substantially continuous. In other words, the barrier film may be provided as a single continuous piece of (e.g. planar) material. In this way, the barrier film may be configured so as to be devoid of any holes, openings, spaces or apertures, which would otherwise provide a pathway through which ingressive elements (e.g. gas and/or liquid molecules) could flow towards the solar cells. In arrangements where the laminate interlayer comprises two or more non-contiguous regions, the barrier film may be substantially continuous within each defined region of the laminate interlayer. In this way, the number of holes, openings, spaces or apertures through the laminate interlayer can be limited only to the spaces between said non-contiguous regions.

The electrically insulating layer may be laminated on the metallic barrier film via an adhesive layer. Any suitable adhesive may be used. One example of a suitable adhesive is an acrylic adhesive. Accordingly, the laminate interlayer may comprise or consist of the following layers: electrically insulating layer, adhesive layer, metallic barrier film (in that order, from the front face side of the module to the back face side of the module).

The laminate interlayer may comprise one or more primer layers disposed on a front face side and/or a back face side of the interlayer. Provision of such primer layers can provide for improved adhesion between the laminate interlayer and adjacent layers of the solar module during manufacture. For example, the use of a primer layer can give a strong adhesion with EVA of around 150 N/cm, in comparison to arrangements where the laminate interlayer is attached directly to adjacent layers of the solar module with e.g. acrylic glue, which would provide an adhesion strength of around 5-10 N/cm.

Preferably, the laminate interlayer comprises both a front face side primer layer, and a back face side primer layer. Accordingly, the structure of the laminate interlayer may comprise or consist of the following layers: front face side primer layer, electrically insulating layer, adhesive layer, metallic barrier film, back face side primer layer (in that order, from the front face side of the module to the back face side of the module).

The one or more primer layers may comprise a polyolefin material. It will be understood that a polyefin defines a type of polymer produced from a simple olefin monomer (e.g. CₙH₂ₙ). The polyolefin material may refer to a polymer/filler blend being at least partially formed of a thermoplastic and an elastomer. Each of the one or more primer layers may comprise a material selected from the group consisting of: ethylene vinyl acetate (EVA), polyethylenes (PE) including linear low-density polyethylene (LLDPE), or polyolefin-elastomers (POE).

Where one or more primer layers are present as part of the laminate interlayer, these may be laminated on the electrically insulating layer and/or metallic barrier film via an adhesive layer. Any suitable adhesive may be used. One example of a suitable adhesive is an acrylic adhesive. Accordingly the laminate interlayer may comprise or consist of the following layers: front face side primer layer, adhesive layer, electrically insulating layer, adhesive layer, metallic barrier film, adhesive layer, back face side primer layer (in that order, from the front face side of the module to the back face side of the module).

Optional features relating to the overall architecture of the device will now be discussed
The specific construction and configuration of the one or more solar cells is not particularly limited, and some benefit of the proposed laminate interlayer may be realised independently of the specific nature of the solar cells in the module. However, whilst the invention is applicable to virtually all types of solar cells, the invention may have particular advantages when the solar cells are heterojunction technology (HJT) type solar cells. HJT type solar cells are so named because they combine two different materials to create a charge separating field at the p-n junction. They can offer improved performance in comparison to more traditional solar cells, however, typically require a solar module incorporating such cells to provide better heat dissipation and better moisture resistance to ensure suitable product reliability. As discussed above, provision of a suitable laminate interlayer can allow for both reduction in permeation of ingressive gas and/or liquid molecules into the solar module, and improved heat transfer away from the solar cells, whilst reducing problems associated with known alternative module architectures suitable for use with HJT solar cells. The solar module is therefore preferably a heterojunction technology (HJT) solar module comprising one or more heterojunction technology (HJT) solar cells.

The solar module comprises one or more solar cells. Preferably, the solar module comprises a plurality of solar cells. Where the solar module comprises a plurality of solar cells, these may be arranged in an array. The array of solar cells may be arranged in an array which extends in a longitudinal (e.g. lengthwise) and/or a transverse (e.g. widthways) direction of the solar module. The solar cells may be arranged in a grid formation, such as a rectangular or square grid pattern.

Where more than one solar cell is present, some or all of the solar cells may be arranged in substantially the same plane. Accordingly, the solar cells may be arranged in a substantially planar array. The solar cells may each be arranged so that they are aligned within the same reference plane. For example, a first solar cell may be arranged, e.g. orientated, such that a horizontal plane of the first solar cell is aligned with a horizontal plane of a second solar cell. The reference plane of the first and second solar cells may be substantially aligned (e.g. parallel) with a horizontal plane of the solar module. Alternatively, some or all of the solar cells may be arranged in a shingling or shingled arrangement. As such, a first solar cell may be arranged to at least partially overlap a second solar cell.

Typically, the one or more solar cells within the module are electrically connected in series or in parallel with one another. In some arrangements, all of the solar cells within a module may be connected in series. In other arrangements, a selected number of solar cells may be connected in series as a solar cell string. Multiple solar cell strings may be connected in parallel, via one or more bypass diodes. Multiple possible solar cell arrangements are well-known in the art, and any suitable arrangement may be used in the present module.

The one or more solar cells are electrically connected to a terminal of the module via one or more electrically conductive interconnect members. In this context, the term "terminal" is intended to refer to the point at which an electric circuit of the module comes to an end. This may be at e.g. an electrical connector. The term "via" is used in this context to indicate that the one or more electrically conductive interconnect members may form only part of a conductive path from the one or more solar cells to the terminal. One or more further conductive elements, (for example electrodes, wires, and/or busbars) may be provided as part of the conductive path.

The one or more electrically conductive interconnect members may connect at a first end, directly or indirectly, to one or more electrodes provided on each of the one or more solar cells. The one or more electrodes may be configured to extract photo-generated charge carriers from the solar cell(s). The one or more electrodes may comprise front electrodes arranged on a front surface of the respective solar cell, and/or back electrodes arranged on a back surface of the respective solar cell. In other words, the solar cells may be front-contact cells, back-contact cells, or cells having both front and back contacts. The front and/or back electrodes may each comprise a plurality of finger electrodes. Each finger electrode may be configured with an axial length which is substantially greater than its width. Both the width and axial length of the finger electrode may be measured in perpendicular directions in the plane of the respective surface of the solar cell. The finger electrodes may extend in a transverse direction which is parallel with the width direction of the solar cell. The finger electrodes within each of the pluralities of front and/or back finger electrodes may be spaced apart across the respective front and back surfaces of the solar cell to define transversely-extending spaces between the finger electrodes. The finger electrodes may be spaced apart in a longitudinal direction which is substantially parallel with the length direction of the solar cell. The finger electrodes in each plurality may be substantially parallel to one another. Accordingly, the plurality of back finger electrodes may form an array of parallel, longitudinally spaced (e.g. equally spaced) finger electrodes.

The one or more electrically conductive interconnect members may connect at a second end, directly or indirectly, to a terminal of the module. They may connect to said terminal via one or more bypass diodes. The terminal may be located within a junction box of the solar module. A junction box typically comprises one or more plug connectors which can allow for efficient connection of the solar module to one or more further solar modules, or other devices, such as batteries or inverters. Where the module comprises a junction box, this may comprise a housing component arranged on a back face side of the solar module. In some arrangements, the solar module may comprise multiple junction boxes (e.g. in a split junction box arrangement), for example as disclosed in European patent EP3017520B1 in the name of REC Solar Pte. Ltd. Where the solar module comprises multiple junction boxes, separate electrically conductive interconnect members may be provided for connection to each separate junction box. For example, where the two junction boxes are present, at least two electrically conductive interconnect members may be provided, for allow for connection of the solar cells to each of the two junction boxes.

The electrically conductive interconnect members may themselves be formed as a conductive wire portion, a foil strip, and/or a busbar. Preferably, the one or more electrically conductive interconnect members are interconnect busbars (ICB). Where the one or more electrically conductive interconnect members are interconnect busbars, these may have a conventional structure, e.g. copper core with tin/lead plating or any solderable alloy.

At least a portion of the one or more electrically conductive interconnect member(s) may extend substantially in a height/thickness direction of the solar module. Said portion may extend in a thickness direction from a horizontal plane in which the one or more solar cells lie, to a terminal of the module. Where the terminal is located on a back face side of the module, said portion of the electrically conductive interconnect member(s) may therefore extend in a thickness direction from a horizontal plane in which the one or more solar cells lie, to a back face side of the module. Said portion may therefore extend through one or more layers constituting the solar module. For example, said portion may extend through the encapsulant surrounding the one or more solar cells. Said portion may extend through a horizontal plane in which the laminate interlayer lies.

The encapsulant may be configured to provide encapsulation of the one or more solar cells. In general, this may be defined as a means of physically protecting the solar cells from external environmental conditions, which may include humidity, moisture, rain and ultraviolet radiation (UV). The encapsulant may also be configured to hold the components of the solar module (e.g. the solar cells) in position within the module. The encapsulant may be configured to protect the solar cells from mechanical stresses such as twisting or bending, and low-energy impacts caused by hail or errant projectiles.

The encapsulant may comprise a front encapsulant layer, and a back encapsulant layer. The front encapsulant layer may be directly or indirectly disposed on a front face side of the solar cells. The back encapsulant layer may be directly or indirectly disposed on a back face side of the solar cells. The front encapsulant layer and the back encapsulant layer may be formed of the same material. Alternatively, the front encapsulant layer and the back encapsulant layer may be formed of different materials. The material of the front and/or back encapsulant layers may be selected from ethylene vinyl acetate (EVA), a polyolefin-elastomer (POE) material, or any other suitable encapsulant material known in the art. Selection of the materials for the front and back encapsulant layers will depend on cell characteristics. For example, POE may be used where better volume resistivity and water vapor transmission rate (WVTR) is required. EVA may be use where a lower cost material is required. In one preferred arrangement, the front encapsulant is formed of a polyolefin-elastomer (POE), and the back encapsulant is formed of ethylene vinyl acetate (EVA).

The encapsulant may have a thickness which is significantly smaller than its length and width. For example, the thickness of the encapsulant may be in a range of from 0.40 mm to 0.65 mm, e.g. about 0.45 mm, about 0.5 mm, about 0.55 mm or about 0.6 mm. The lateral extent of the encapsulant may be substantially the same as the lateral extent of the backsheet of the module.

The solar module may comprise an outer casing, wherein the insulating backsheet forms a part of said outer casing. The outer casing may further comprise a front sheet, or front plate, arranged on a front side of the solar module. The front sheet may be formed of a transparent material, such as glass.

The insulating backsheet may be formed of any suitable insulating material. In preferred arrangements, the backsheet is polymeric, e.g. formed of polyethylene terephthalate (PET). Use of polymer can provide for a cost-effective backsheet which nevertheless provides suitable protection for other module components.

The solar module may include a frame, or one or more frame elements. The frame may be configured to hold the components of the solar module in place and to provide sealing around the perimeter of the outer casing (e.g. the front and back sheets). Where the solar module comprises a front sheet and a back sheet, the frame may apply a compressive force between the front and back sheet in order to retain the components of the solar module in position, as would be readily understood by the skilled person.

According to a second aspect there is provided a method for manufacturing a solar module as set out in claim 14.

The steps as set out in the above method may not be performed in the order stated. For example, the step of arranging a laminate interlayer to be interposed between the encapsulant and the backsheet of the solar module may be performed between the steps of arranging an encapsulant to surround the one or more solar cells, and arranging a backsheet to overlay the one or more solar cells and encapsulant on a back face side of the module.

In some methods, the laminate interlayer may be attached to the backsheet before the backsheet is arranged to overlay the one or more solar modules and encapsulant on a back face side of the module. **In** such a method, the steps of 'arranging a backsheet to overlay the one or more solar cells and encapsulant on a back face side of the module' and 'arranging a laminate interlayer having a lateral extent less than the lateral extent of the backsheet to be interposed between the encapsulant and the backsheet of the solar module' can therefore be performed in the same single method step of arranging a combination interlayer-backsheet to overlay the one or more solar cells and encapsulant on a back face side of the module. This may reduce the total number of manufacturing steps required during manufacture of the solar module. Where the laminate interlayer is attached to the backsheet before final module assemble, such attachment may be achieved by chemical and/or physical attachment, e.g. by applying an adhesive, or by attaching the laminate interlayer and the backsheet using a mechanical press.

The step of providing one or more solar cells may include providing the one or more solar cells by a manufacturing process, or, alternatively may include obtaining the one or more solar cells from another party, for example, from a manufacturer.

The step of arranging an encapsulant to surround the one or more solar cells may include sub-steps of arranging a front encapsulant layer on a front face side of the one or more solar cells, and arranging a back encapsulant layer on a back face side of the one or more solar cells.

As discussed above, the laminate interlayer comprises two or more non-contiguous regions. Accordingly, the step of arranging a laminate interlayer having a lateral extent less than the lateral extent of the backsheet to be interposed between the encapsulant and the backsheet of the solar module may include sub-steps of arranging a first portion of the laminate interlay, and arranging a second portion of the laminate interlayer.

The method may comprise one or more steps of applying heat and/or pressure. Application of heat and/or pressure may promote adherence of one or more elements of the module to one another.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### SUMMARY OF THE FIGURES

Embodiments and experiments illustrating the principles of the invention will now be discussed with reference to the accompanying figures in which:
Figs. 1A and 1B respectively show schematic plan and sectional side views of a solar module according to the present invention.
Fig. 2A and 2B respectively show a partial schematic cross section through a solar module according to the present invention; and a schematic plan view of the relative arrangement of the laminate interlayer in relation to selected other components of the same module.
Fig. 3 is a flowchart illustrating a method of manufacturing the solar module of Fig. 1.

### DETAILED DESCRIPTION OF THE INVENTION

Aspects and embodiments of the present invention will now be discussed with reference to the accompanying figures. Further aspects and embodiments will be apparent to those skilled in the art. All documents mentioned in this text are incorporated herein by reference.

In the drawings, the relative dimensions of various elements of the solar module are shown schematically and are not to scale. For example, the thickness of sheets, layers, films, etc., are exaggerated for clarity. Furthermore, it will be understood that when an element such as a layer, film, region, or substrate is referred to or shown as being "on" or "adjacent" another element, it can be directly on the other element or intervening elements may also be present. In contrast, when an element is referred to as being "directly on" or "directly adjacent" another element, there are no intervening elements present.

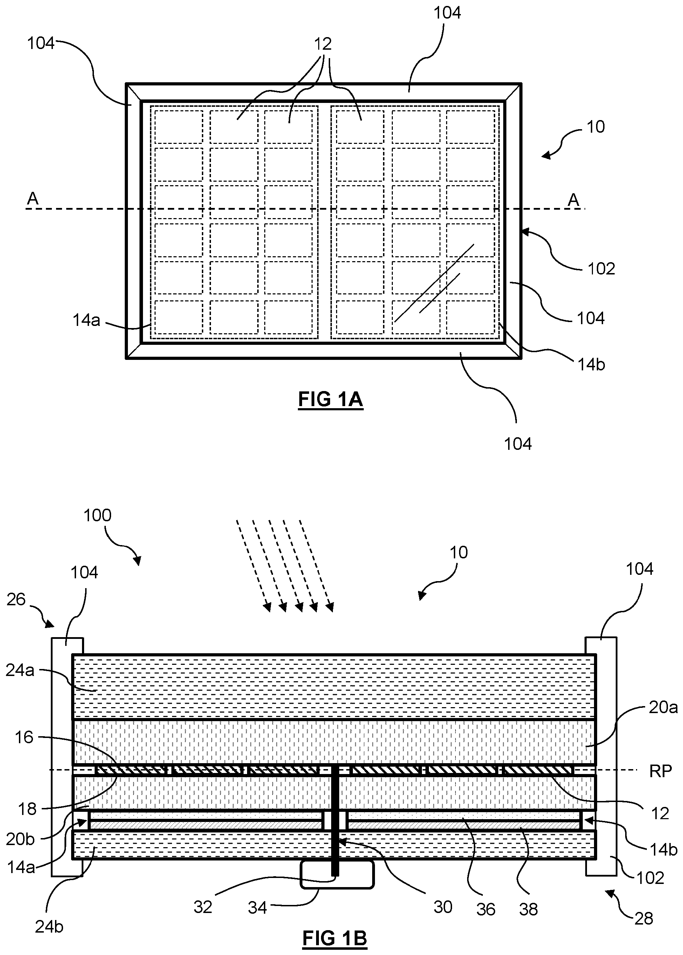

Fig. 1A and Fig 1B illustrate a solar module 10 according to the present invention. The solar module 10 includes an array of solar cells 12 arranged in a grid-like pattern. The solar cells 12 are sandwiched between a transparent glass sheet 24a at a front face side 26 of the solar module 10 and an insulating backsheet 24b arranged at a back face side 28 of the solar module 10. As such, the insulating back sheet 24b and the transparent glass sheet 24a define front and back outer casings of the solar module 10, respectively.

The solar module 10 is mounted within a rectangular frame 102, which extends about a periphery of the solar module 10. The frame 102 protects the edges of the solar module 10 and provides a means for mounting the solar module 10 to a structure (e.g. a building roof). The frame 102 comprises four elongate frame members 104 that are each mounted to, and extend along, a respective edge of the solar module 10. The frame is formed from a conductive material, such as aluminium.

Fig. 1A illustrates the top (front) view of the solar module 10, whereas Fig. 1B depicts a transverse section of the solar module 10 taken along the dashed lines A-A, as shown in Fig. 1A. The solar module 10 has a length which is the horizontal dimension of Fig. 1A (i.e. along direction A-A), and a width which is the vertical dimension of Fig. 1A (i.e. perpendicular to direction A-A).

Fig 1B depicts a plurality of solar cells 12 arranged in a substantially horizontal reference plane RP of the solar module 10. The reference plane RP is substantially parallel to the front and back outer casings of the solar module 10 and extends substantially centrally therebetween. Each one of the plurality of solar cells 12 is a heterojunction technology (HJT) solar cell.

The arrows at the top of Fig. 1B show the direction of the solar radiation which is incident upon the solar module 10. Each of the solar cells 12 has a front surface 16 (upon which light is incident in normal use) and a rear surface 18 opposite the front surface 16. The front surface is configured in use to substantially face the sun. The transparent glass sheet 24a allows light to pass through into a central chamber in which the solar cells 12 are mounted. The front encapsulant 20a is also transparent to allow incident light to reach the solar cells 12. The back encapsulant 20b may also be transparent, although this is not essential.

The solar cells 12 are arranged in a planar array which extends in both a lengthways and a widthways direction of the solar module 10, as shown in Fig. 1A. The planar array comprises two sub-arrays, with a spacing being provided between the two sub-arrays such that conductive elements extending from the solar cells in each sub array can lie within this spacing gap between the two sub arrays.

The solar cells 12 are surrounded by an encapsulant 20a, 20b, which helps to secure the various components of the solar module 10 in position. The encapsulant 20a, 20b protects the solar cells 12 from both mechanical and chemical damage, which may otherwise degrade the solar cells 12. The front encapsulant 20a is formed of a polyolefin-elastomer (POE), and the back encapsulant 20b is formed of ethylene vinyl acetate (EVA). The front encapsulant 20a and the back encapsulant 20b both have a thickness in the range of from 0.40 mm to 0.65 mm.

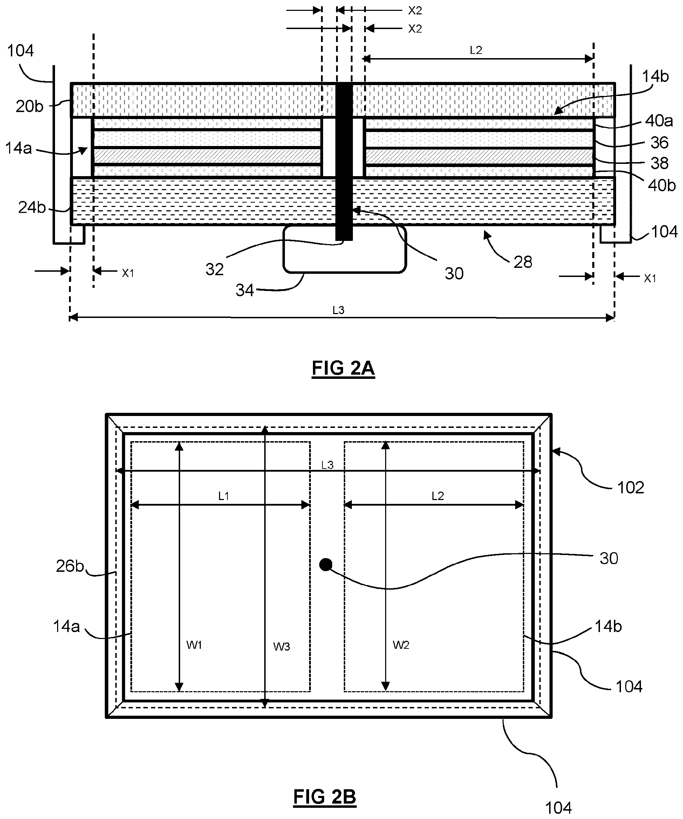

A laminate interlayer 14a, 14b is interposed between the encapsulant and the backsheet. The laminate interlayer is formed of a first part 14a, and a second part 14b, wherein the first and second parts of the laminate each extend in both the lengthwise and widthways directions of the solar module so as to overlay the plurality of solar cells 12 on a back face side. The lateral extent of the laminate interlayer is less than the lateral extent of the insulating backsheet. The laminate interlayer comprises an electrically insulating layer 36 and a metallic barrier film 38. The structure of the laminate interlayer, and its relative arrangement in relation to other elements of the solar module will be discussed in greater detail in relation to Fig. 2, below.

The solar cell 12 are electrically connected via an electrically conductive interconnect member 30 to a terminal 32 located in a junction box 34. The junction box 34 is located on a back face side of the solar module 10. The one or more electrically conductive interconnect members 30 form only part of a conductive path from the one or more solar cells to the terminal, the remainder of the conductive path being provided by further conductive elements (for example electrodes, wires, and/or busbars) which are not illustrated here, but the configuration and layout of which will be within the common general knowledge of the person skilled in the art. The electrically conductive interconnect member 30 extends in a thickness direction of the solar module, from the horizontal reference plane RP in which the solar cells lie, to a back face side 28 of the module. A portion of the electrically conductive interconnect member therefore extends through one or more layers constituting the solar module - here, it extends through the back encapsulant layer 20b, and the insulating backsheet 24b. This portion also extends through a horizontal plane in which the laminate interlayer lies, but does not intersect or touch the laminate interlayer. Rather, as discussed below in relation to Fig. 2, a lateral spacing is provided between the laminate interlayer and the electrically conductive interconnect member.

Fig. 2A and 2B show the relative arrangement of the laminate interlayer with respect to other elements of the solar module in greater detail. Fig. 2A shows a schematic partial cross section through a solar module according to the present invention. For simplicity, the cross section only illustrates layers of the solar module between the back encapsulant layer 20b and the insulating backsheet 24b. Fig. 2B shows a schematic plan view of the relative arrangement of the laminate interlayer 14a, 14b with respect to the backsheet 24b, the perimeter frame 102, and the electrically conductive interconnect member 30.

The lateral extent of the laminate interlayer is less than the lateral extent of the insulating backsheet. Indeed, in this arrangement, each edge of the laminate interlayer underlaps a respective edge of the backsheet in a lateral direction.

In this embodiment, the laminate interlayer comprises two separate parts 14a, 14b, which do not touch one another or otherwise intersect, i.e. they are formed as non-contiguous regions.

The two regions 14a and 14b of the laminate interlayer are substantially identical in shape, size and construction. It can therefore be seen from Fig. 2A and 2B, that the laminate interlayer extends in a length direction of the solar module for a total length of L1 + L2. The backsheet extends in a length direction of the solar module for a length L3. The laminate interlayer extends in a width direction of the solar module for a total width of W1 + W2. The backsheet extends in a width direction of the solar module for a width W3. The total lateral extent (i.e. the area) of the laminate interlayer is therefore calculated as (L1*W1)+(L2*W2). The total lateral extent of the backsheet is calculated as L3*W3. (L1*W1)+(L2*W2) < L3*W3. In this exemplary embodiment, L1 and L2 are each 830 mm, W1 and W2 are each 985 mm, L3 is 1713 mm, and W3 is 1020 mm. The lateral extent of the laminate interlayer is about 1.64 m². The total lateral extent of the backsheet is about 1.75 m².

Because the lateral extent of the laminate interlayer is less than the lateral extent of the insulating backsheet by virtue of each edge of the laminate interlayer underlapping a respective edge of the backsheet in a lateral direction, it is possible for the backsheet and one or more further elements of the solar module (e.g. the encapsulant) to directly contact the frame 102 on each major edge, whilst the laminate interlayer remains spaced from the frame.

The laminate interlayer comprises an electrically insulating layer 36 and a metallic barrier film 38 arranged in that order from a front face side of the module to the back face side of the module. The laminate interlay further comprises both a front face side primer layer 40a, and a back face side primer layer 40b. The front face side primer layer is disposed on a front face side the electrically insulating layer 36 via an adhesive layer (not shown). The back face side primer layer is disposed on a back face side of the metallic barrier film 38 via an adhesive layer (not shown). The structure of the laminate interlayer is therefore as follows: front face side primer layer, adhesive, electrically insulating layer, metallic barrier film, adhesive, back face side primer layer, in that order.

The electrically insulating layer 36 is a PET layer having a thickness of about 0.01 mm, which was selected based on the requirements for layer thickness given in the row headed "Thickness of thin layers" in Table 3 of IEC 61730-1:2016. As PET has an RTI of greater than 90 °C, it meets the IEC standards for distance through insulation as defined in IEC 61730-1:2016, and therefore provides for suitable insulation between the solar cells (not shown in Fig. 2) and the metallic barrier film. This is advantageous, as typically the material use for the encapsulant layer (here, EVA), does not have a suitable high RTI to qualify as a suitable material for providing distance through insulation, as set out in Table 3 of IEC 61730-1:2016.

The metallic barrier film is an aluminium foil layer. Commercially-available aluminium foil layers are typically available in thicknesses of e.g. 7 µm, 9 µm, 11 µm, or greater. Conveniently, the metallic barrier film in this embodiment is a commercially-available aluminium foil having a thickness of 7 µm. Using a thin foil can reduce the overall module weight. The barrier film 38 is substantially continuous within each defined region 14a, 14b of the laminate interlayer. In this way, the number of holes, openings, spaces or apertures through the laminate interlayer can be minimised.

Each of the front face side primer layer 40a, and the back face side primer layer 40b comprise a polyolefin material. This allows for improved adhesion of the laminate interlayer to the back encapsulant layer 20b and to the insulating backsheet 24b.

As described in relation to Fig. 1A and Fig. 1B, the solar module 10 is mounted within a rectangular frame 102, which extends about a periphery of the solar module 10. The frame 102 protects the edges of the solar module 10 and provides a means for mounting the solar module 10 to a structure (e.g. a building roof). The frame 102 comprises four elongate frame members 104 that are each mounted to, and extend along, a respective edge of the solar module 10. The frame is formed from a conductive material, such as aluminium.

The module is a module having a single module V_{OC} of around 50V, for installation in a system comprising a plurality of such modules, with a total system voltage of around 1500V. The pollution degree of the module for calculation of all creepage distances is 1.

A first predetermined minimum creepage distance X1 is provided between an edge of the laminate interlayer and the electrically conductive frame members. This first predetermined minimum creepage distance is selected to be greater than or equal to the value given in Row 1(a) of Table 3 of IEC 61730-1:2016 for at least the single module voltage, and the pollution degree of the module. In this case, the total system voltage of 1500V is considered, and as such the first predetermined minimum creepage distance is selected to be greater than or equal to 10.4 mm based on Table 3 of IEC 61730-1:2016, and is 12 mm in this embodiment. This first minimum creepage distance is defined as the shortest distance along the surface of a solid insulating material (here, along the front face side surface of the insulating backsheet) between the metallic barrier film 38 of the laminate interlayer and the electrically conductive frame member 104. For avoidance of doubt, the distance along the edge of the primer layer is not included when calculating this creepage distance, as the primer layer's RTI value will typically be less than 90 °C, and therefore does not meet the IEC standards to be included when calculating distance through insulation, creepage distances (cr) or clearances (cl) for Class II PV modules as defined in IEC 61730-1:2016. The term 'insulating material' in this context therefore includes materials having an RTI value of 90 °C or more.

As described in relation to Fig. 1B, the electrically conductive interconnect member 30 extends in a thickness direction of the solar module, from the horizontal reference plane RP in which the solar cells lie (not shown), to a back face side 28 of the module. A portion of the electrically conductive interconnect member therefore extends through the back encapsulant layer 20b, and the insulating backsheet 24b, as well as through a horizontal plane in which the laminate interlayer lies. A second predetermined minimum creepage distance X2 is provided between an edge of the laminate interlayer and the electrically conductive interconnect member 30. This second predetermined minimum creepage distance is selected based on Table 3 of IEC 61730-1:2016. In this case the single module V_{OC} is considered, and as such, the second predetermined minimum creepage distance is selected to be greater than or equal to 0.5 mm based on Table 3 of IEC 61730-1:2016, and is 0.5 mm in this embodiment. This second minimum creepage distance is defined as the shortest distance along the surface of a solid insulating material (here, along the front face side surface of the insulating backsheet) between the metallic barrier film 38 of the laminate interlayer and the electrically conductive interconnect member 30. For avoidance of doubt, the distance along the edge of the primer layer is not included when calculating this creepage distance, as the primer layer's RTI value will typically be less than 90 °C, and therefore does not meet the IEC standards to be included when calculating distance through insulation, creepage distances (cr) or clearances (cl) for Class II PV modules as defined in IEC 61730-1:2016. The term 'insulating material' in this context therefore includes materials having an RTI value of 90 °C or more.

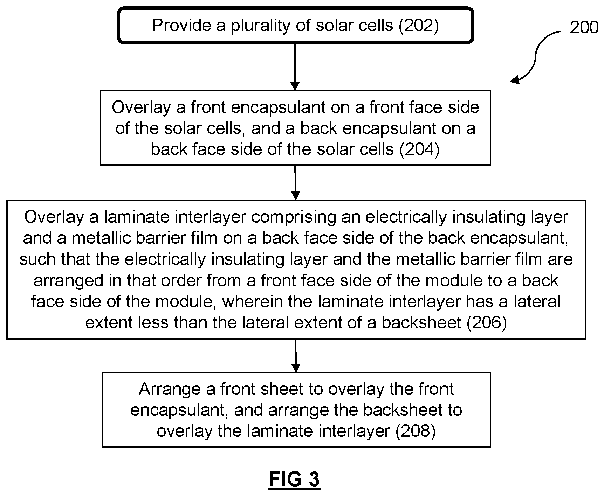

An exemplary method of manufacturing the solar module 10 will now be described with reference to Fig. 3, which illustrates a flow chart of the corresponding method steps.

The method 200 commences with a first step 202 in which a plurality of solar cells 12 are provided. According to an exemplary arrangement, the plurality of solar cells 12 are arranged in a planar array or grid, as described above with reference to Figs. 1A and 1B.

The method then proceeds to step 204 in which a front encapsulant 20a is overlaid on a front face side of the solar cells, and a back encapsulant 20b is overlaid on a back face side of the solar cells to surround the cells. The method step 204 includes an optional step of applying heat and pressure to front and back encapsulant so as to adhere them to the respective surfaces of the solar cells 12. According to an exemplary method, the front and back encapsulant are configured such that the heat at least partially melts the encapsulant and the pressure then fixes them to the cells 12 as the encapsulant layers cool.

The method then proceeds to step 206 in which a laminate interlayer 14a, 14b comprising an electrically insulating layer 36 and a metallic barrier film 38 is overlaid on a back face side of the back encapsulant 20b. The laminate interlayer is overlaid on the encapsulant such that the electrically insulating layer and the metallic barrier film are arranged in that order from a front face side of the module to a back face side of the module. The laminate interlayer has a lateral extent less than the lateral extent of a backsheet, which is arranged in a subsequent step.

The method then proceeds to step 208 in which a transparent glass sheet 24a is overlaid onto the front surface of the front encapsulant 20a, and an insulating backsheet is overlaid onto the back surface of laminate interlayer, thereby assembling the exemplary solar module 10 as shown in Fig. 1. The method step 208 includes an optional further application of heat and pressure so as to adhere the front encapsulants 20a to the transparent glass sheet 24a and laminate interlayer 14, 14b to the backsheet 24b, respectively.

The module architecture described here results in a module having similar or improved reliability as compared with conventional modules having a pure aluminium backsheet (by providing a suitable reduction in permeation of ingressive gas and/or liquid molecules into the solar module, and by providing improved heat transfer away from the solar cells), but with reduced risk of static buildup and discharge between conductive parts of the module due to the lateral spacing provided between the laminate interlayer and other portions of the solar module. Furthermore, the module can meet safety standards as set out in IEC 61730-1:2016, whilst being relatively easy to manufacture.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the scope of the invention defined by the claims.

For the avoidance of any doubt, any theoretical explanations provided herein are provided for the purposes of improving the understanding of a reader. The inventors do not wish to be bound by any of these theoretical explanations.

Any section headings used herein are for organizational purposes only and are not to be construed as limiting the subject matter described.

Throughout this specification, including the claims which follow, unless the context requires otherwise, the word "comprise" and "include", and variations such as "comprises", "comprising", and "including" will be understood to imply the inclusion of a stated integer or step or group of integers or steps but not the exclusion of any other integer or step or group of integers or steps. It must be noted that, as used in the specification and the appended claims, the singular forms "a," "an," and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by the use of the antecedent "about," it will be understood that the particular value forms another embodiment. The term "about" in relation to a numerical value is optional and means for example +/- 10%.

## Claims

1. A solar module (10) comprising:
one or more solar cells (12) having a front face (16) and a back face (18), said solar cells being electrically connected to a terminal via one or more electrically conductive interconnect members (30), and surrounded by an encapsulant (20a, 20b);
an insulating backsheet (24b) arranged to overlay the one or more solar cells and encapsulant on a back face side of the module; and
a laminate interlayer (14, 14b) interposed between the encapsulant (20a, 20b) and the backsheet (24b), the laminate interlayer comprising an electrically insulating layer (36) and a metallic barrier film (38) arranged in that order from a front face side of the module to the back face side of the module;
wherein the laminate interlayer (14, 14b) has a lateral extent less than the lateral extent of the backsheet (24b); and
**characterised in that** the laminate interlayer (14, 14b) comprises two or more non-contiguous regions.

2. The solar module (10) according to claim 1, wherein one or both of (i) and (ii) applies:
(i) wherein the solar module (10) further comprises an electrically conductive frame (102) and wherein a first predetermined minimum creepage distance is provided between an edge of the laminate interlayer (14, 14b) and the electrically conductive frame;
(ii) wherein the one or more electrically conductive interconnect members (30) extend through a horizontal plane in which the laminate interlayer (14, 14b) lies, and wherein a second predetermined minimum creepage distance is provided between an edge of the laminate interlayer and the one or more electrically conductive interconnect members, optionally wherein the first and/or second predetermined minimum creepage distances are selected based on Table 3 of IEC 61730-1:2016.

3. The solar module (10) according to claim 2 wherein:
(i) applies, and wherein the first predetermined minimum creepage distance is selected to be greater than or equal to the value given in Row 1(a) or Row 3 of Table 3 of IEC 61730-1:2016 for at least the single module voltage or V_{OC}, and the pollution degree of the module; and/or
(ii) applies, and wherein the second predetermined minimum creepage distance is selected to be greater than or equal to the value given in Row 1(a) or Row 3 of Table 3 of IEC 61730-1:2016 for at least the single module voltage or V_{OC}, and the pollution degree of the module.

4. The solar module (10) according to any one of the preceding claims wherein the laminate interlayer substantially overlays all of the one or more solar cells on a back face side.

5. The solar module (10) according to any one of claims 2 to 4, wherein (ii) applies, and wherein the one or more electrically conductive interconnect members (30) extend through a gap between the non-contiguous regions of the interlayer.

6. The solar module (10) according to any one of the preceding claims wherein the one or more electrically conductive interconnect members (30) comprises an interconnect busbar.

7. The solar module (10) according to any one of the preceding claims wherein the terminal is located on a back face side of the module.

8. The solar module (10) according to any one of the preceding claims wherein the electrically insulating layer has a relative thermal index (RTI) of greater than 90 °C.

9. The solar module according to any one of the preceding claims wherein the electrically insulating layer (36) comprises a material selected from the group consisting of: polyethylene terephthalate (PET), polyolefins (PO), polyamides (PA), and polycarbonates (PC), optionally wherein the electrically insulating layer (36) has a thickness of 0.01 mm or more.

10. The solar module (10) according to any one of the preceding claims wherein the metallic barrier film (38) comprises a foil layer, optionally an aluminium foil layer or a copper foil layer, optionally the metallic barrier film (38) has a thickness of 5 µm or more.

11. The solar module (10) according to any one of the preceding claims wherein the laminate interlayer comprises one or more primer layers (40a, 40b) disposed on a front face side and/or a back face side of the interlayer;
optionally wherein the one or more primer layers (40a, 40b) comprise a polyolefin material;
further optionally wherein each of the one or more primer layers (40a, 40b) comprises a material selected from the group consisting of: ethylene vinyl acetate (EVA), polyethylenes (PE) including linear low-density polyethylene (LLDPE), and polyolefin-elastomers (POE).

12. The solar module (10) according to claim 11 wherein the one or more primer layers (40a, 40b) are laminated on the electrically insulating layer (36) and/or metallic barrier film (38) via an adhesive layer.

13. The solar module (10) according to any one of the preceding claims wherein the one or more solar cells (12) are heterojunction technology (HJT) cells.

14. A method for manufacturing a solar module (10), the method including steps of:
(i) providing one or more solar cells (12), said solar cells being electrically connected to a terminal via one or more electrically conductive interconnect members (30);
(ii) arranging an encapsulant (20a, 20b) to surround the one or more solar cells;
(iii) arranging a backsheet (24b) to overlay the one or more solar cells and encapsulant on a back face side of the module; and
(iv) arranging a laminate interlayer (14a, 14b) having a lateral extent less than the lateral extent of the backsheet (24b) to be interposed between the encapsulant and the backsheet of the solar module, wherein the laminate interlayer (14a, 14b) comprises an electrically insulating layer (36) and a metallic barrier film (38) arranged in that order from a front face side of the module to the back face side of the module; and
**characterised in that** the laminate interlayer (14a, 14b) comprises two or more non-contiguous regions.

15. The method according to claim 14 wherein the step (iv) of arranging a laminate interlayer (14a, 14b) to be interposed between the encapsulant and the backsheet of the solar module is performed between the steps (ii) of arranging an encapsulant (20a, 20b) to surround the one or more solar cells, and (iii) of arranging a backsheet (24b) to overlay the one or more solar cells and encapsulant on a back face side of the module, optionally wherein the laminate interlayer (14a, 14b) is attached to the backsheet (24b) before the backsheet is arranged to overlay the one or more solar cells (12) and encapsulant on a back face side of the module, and wherein steps (iii) and (iv) are performed as a single method step of arranging a combination interlayer-backsheet to overlay the one or more solar cells (12) and encapsulant on a back face side of the module.

## Patentansprüche

1. Solarmodul (10), umfassend:
eine oder mehrere Solarzellen (12) mit einer Vorderseite (16) und einer Rückseite (18), wobei die Solarzellen über ein oder mehrere elektrisch leitfähige Zwischenverbindungselemente (30) elektrisch mit einem Anschluss verbunden und von einem Verkapselungsmaterial (20a, 20b) umgeben sind;
eine isolierende Rückseitenfolie (24b), die angeordnet ist, um die eine oder die mehreren Solarzellen und das Verkapselungsmaterial auf einer Rückseitenseite des Moduls zu überlagern; und
eine Laminatzwischenschicht (14, 14b), die zwischen dem Verkapselungsmaterial (20a, 20b) und der Rückseitenfolie (24b) angeordnet ist, wobei die Laminatzwischenschicht eine elektrisch isolierende Schicht (36) und einen metallischen Sperrfilm (38) umfasst, die in dieser Reihenfolge von einer Vorderseitenseite des Moduls zu der Rückseitenseite des Moduls hin angeordnet sind;
wobei die Laminatzwischenschicht (14, 14b) eine seitliche Ausdehnung aufweist, die kleiner als die seitliche Ausdehnung der Rückseitenfolie (24b) ist; und
**dadurch gekennzeichnet, dass** die Laminatzwischenschicht (14, 14b) zwei oder mehrere nichtzusammenhängende Bereiche umfasst.

2. Solarmodul (10) nach Anspruch 1, wobei eines oder beides aus (i) oder (ii) zutrifft:
(i) wobei das Solarmodul (10) ferner einen elektrisch leitfähigen Rahmen (102) umfasst und wobei eine erste vorbestimmte Mindestkriechstrecke zwischen einer Kante der Laminatzwischenschicht (14, 14b) und dem elektrisch leitfähigen Rahmen bereitgestellt ist;
(ii) wobei das eine oder die mehreren elektrisch leitfähigen Zwischenverbindungselemente (30) sich über eine horizontale Ebene erstrecken, in der die Laminatzwischenschicht (14, 14b) liegt und wobei eine zweite vorbestimmte Mindestkriechstrecke zwischen einer Kante der Laminatzwischenschicht und dem einen oder den mehreren elektrisch leitfähigen Zwischenverbindungselementen bereitgestellt ist, wobei die erste und/oder die zweite vorbestimmte Mindestkriechstrecke(n) gegebenenfalls basierend auf Tabelle 3 von IEC 61730-1:2016 ausgewählt ist/sind.

3. Solarmodul (10) nach Anspruch 2, wobei:
(i) zutrifft, und wobei die erste vorbestimmte Mindestkriechstrecke ausgewählt ist, um größer oder gleich dem in Zeile 1(a) oder Zeile 3 von Tabelle 3 von IEC 61730-1:2016 angegebenen Wert für zumindest die Einzelmodulspannung oder V_{OC} und das Verschmutzungsausmaß des Moduls zu sein; und/oder wobei
(ii) zutrifft, und wobei die zweite vorbestimmte Mindestkriechstrecke ausgewählt ist, um größer oder gleich dem in Zeile 1(a) oder Zeile 3 von Tabelle 3 von IEC 61730-1:2016 angegebenen Wert für zumindest die Einzelmodulspannung oder V_{OC} und das Verschmutzungsausmaß des Moduls zu sein.

4. Solarmodul (10) nach einem der vorangegangenen Ansprüche, wobei die Laminatzwischenschicht im Wesentlichen alle aus der einen oder den mehreren Solarzellen auf einer Rückseitenseite überlagert.

5. Solarmodul (10) nach einem der Ansprüche 2 bis 4, wobei (ii) zutrifft und wobei das eine oder die mehreren elektrisch leitfähigen Zwischenverbindungselemente (30) sich durch einen Spalt zwischen den nicht zusammenhängenden Bereichen der Zwischenschicht hindurch erstrecken.

6. Solarmodul (10) nach einem aus den vorangegangenen Ansprüchen, wobei die eine oder mehreren elektrisch leitfähigen Zwischenverbindungselemente (30) eine Zwischenverbindungssammelschiene umfasst/umfassen.

7. Solarmodul (10) nach einem aus den vorangegangenen Ansprüchen, wobei der Anschluss an einer Rückseitenseite des Moduls angeordnet ist.

8. Solarmodul (10) nach einem der vorangegangenen Ansprüche, wobei die elektrisch isolierende Schicht einen relativen Temperaturindex (RTI) von größer als 90 °C aufweist.

9. Solarmodul nach einem der vorangegangenen Ansprüche, wobei die elektrisch isolierende Schicht (36) ein Material umfasst, das aus der aus folgenden bestehenden Gruppe ausgewählt ist: Polyethylenterephthalat (PET), Polyolefine (PO), Polyamide (PA) und Polycarbonate (PC), wobei die elektrisch isolierende Schicht (36) gegebenenfalls eine Dicke von 0,01 mm oder mehr aufweist.

10. Solarmodul (10) nach einem der vorangegangenen Ansprüche, wobei der metallische Sperrfilm (38) eine Folienschicht, gegebenenfalls eine Aluminiumfolienschicht oder eine Kupferfolienschicht umfasst, wobei der metallische Sperrfilm (38) gegebenenfalls eine Dicke von 5 µm oder mehr aufweist.

11. Solarmodul (10) nach einem der vorangegangenen Ansprüche, wobei die Laminatzwischenschicht eine oder mehrere Primerschichten (40a, 40b) umfasst, die auf einer Vorderseitenseite und/oder einer Rückseitenseite der Zwischenschicht angeordnet sind;
wobei die eine oder mehreren Primerschichten (40a, 40b) gegebenenfalls ein Polyolefinmaterial umfassen;
wobei ferner die eine oder mehreren Primerschichten (40a, 40b) gegebenenfalls ein Material umfassen, das aus der aus folgenden bestehenden Gruppe ausgewählt ist: Ethylenvinylacetat (EVA), Polyethylene (PE), einschließlich lineares Polyethylen niedriger Dichte (LLDPE), und Polyolefinelastomere (POE).

12. Solarmodul (10) nach Anspruch 11, wobei die eine oder mehreren Primerschichten (40a, 40b) über eine Haftschicht auf die elektrisch isolierende Schicht (36) und/oder den metallischen Sperrfilm (38) laminiert sind.

13. Solarmodul (10) nach einem der vorangegangenen Ansprüche, wobei die eine oder mehreren Solarzellen (12) Heterojunction-Technologie-(HJT-)Zellen sind.

14. Verfahren zur Herstellung eines Solarmoduls (10), wobei das Verfahren folgende Schritte umfasst:
(i) Bereitstellen von einer oder mehreren Solarzellen (12), wobei die Solarzellen über ein oder mehrere elektrisch leitfähige Zwischenverbindungselemente (30) elektrisch mit einem Anschluss verbunden sind;
(ii) Anordnen eines Verkapselungsmaterials (20a, 20b), um die eine oder mehreren Solarzellen zu umgeben;
(iii) Anordnen einer Rückseitenfolie (24b), um die eine oder die mehreren Solarzellen und das Verkapselungsmaterial auf einer Rückseitenseite des Moduls zu überlagern; und
(iv) Anordnen einer Laminatzwischenschicht (14a, 14b), die eine seitliche Erstreckung aufweist, die kleiner als die seitliche Erstreckung der Rückseitenfolie (24b) ist, die zwischen dem Verkapselungsmaterial und der Rückseitenfolie des Solarmoduls anzuordnen ist, wobei die Laminatzwischenschicht (14a, 14b) eine elektrisch isolierende Schicht (36) und einen metallischen Sperrfilm (38) umfasst, die in dieser Reihenfolge von einer Vorderseitenseite des Moduls zu der Rückseitenseite des Moduls hin angeordnet sind;
**dadurch gekennzeichnet, dass** die Laminatzwischenschicht (14a, 14b) zwei oder mehrere nichtzusammenhängende Bereiche umfasst.

15. Verfahren nach Anspruch 14, wobei der Schritt (iv) des Anordnens einer Laminatzwischenschicht (14a, 14b), die zwischen dem Verkapselungsmaterial und der Rückseitenfolie des Solarmoduls anzuordnen ist, zwischen Schritt (ii) des Anordnens eines Verkapselungsmaterials (20a, 20b), um die eine oder mehreren Solarzellen zu umgeben, und Schritt (iii) des Anordnens einer Rückseitenfolie (24b), um die eine oder die mehreren Solarzellen und das Verkapselungsmaterial auf einer Rückseitenseite des Moduls zu überlagern, durchgeführt wird, wobei die Laminatzwischenschicht (14a, 14b) gegebenenfalls an der Rückseitenfolie (24b) befestigt wird, bevor die Rückseitenfolie angeordnet wird, um die einen oder die mehreren Solarzellen (12) und das Verkapselungsmaterial auf einer Rückseitenseite des Moduls zu überlagern, und wobei die Schritte (iii) und (iv) als ein einzelner Verfahrensschritt des Anordnens einer Kombinationszwischenschichtrückseitenfolie, um die eine oder die mehreren Solarzellen (12) und das Verkapselungsmaterial auf einer Rückseitenseite des Moduls zu überlagern, durchgeführt werden.

## Revendications

1. Module solaire (10), comprenant :
une ou plusieurs cellules solaires (12) présentant une face avant (16) et une face arrière (18), lesdites cellules solaires étant connectées électriquement à une borne via un ou plusieurs éléments d'interconnexion électriquement conducteurs (30), et entourées par un agent d'encapsulation (20a, 20b) ;
une feuille arrière isolante (24b) agencée pour recouvrir les une ou plusieurs cellules solaires et l'agent d'encapsulation sur un côté de face arrière du module ; et
une couche intermédiaire stratifiée (14, 14b) interposée entre l'agent d'encapsulation (20a, 20b) et la feuille arrière (24b), la couche intermédiaire stratifiée comprenant une couche électriquement isolante (36) et un film barrière métallique (38) agencés dans cet ordre depuis un côté de face avant du module vers le côté de face arrière du module ;
dans lequel la couche intermédiaire stratifiée (14, 14b) présente une étendue latérale inférieure à l'étendue latérale de la feuille arrière (24b) ; et
**caractérisé en ce que** la couche intermédiaire stratifiée (14, 14b) comprend deux régions non contiguës ou plus.

2. Module solaire (10) selon la revendication 1, dans lequel un ou les deux parmi (i) et (ii) s'appliquent :
(i) dans lequel le module solaire (10) comprend en outre un cadre électriquement conducteur (102) et dans lequel une première ligne de fuite minimale prédéterminée est prévue entre un bord de la couche intermédiaire stratifiée (14, 14b) et le cadre électriquement conducteur ;
(ii) dans lequel les un ou plusieurs éléments d'interconnexion électriquement conducteurs (30) s'étendent à travers un plan horizontal dans lequel se trouve la couche intermédiaire stratifiée (14, 14b), et dans lequel une seconde ligne de fuite minimale prédéterminée est prévue entre un bord de la couche intermédiaire stratifiée et les un ou plusieurs éléments d'interconnexion électriquement conducteurs, facultativement dans lequel les première et/ou seconde lignes de fuite minimales prédéterminées sont sélectionnées sur la base du tableau 3 de la norme IEC 61730-1:2016.

3. Module solaire (10) selon la revendication 2, dans lequel :
(i) s'applique, et dans lequel la première ligne de fuite minimale prédéterminée est sélectionnée pour être supérieure ou égale à la valeur donnée dans la ligne 1(a) ou la ligne 3 du tableau 3 de la norme IEC 61730-1:2016 pour au moins la tension de module unique ou Voc, et le degré de pollution du module ; et/ou
(ii) s'applique, et dans lequel la seconde ligne de fuite minimale prédéterminée est sélectionnée pour être supérieure ou égale à la valeur donnée dans la ligne 1(a) ou la ligne 3 du tableau 3 de la norme IEC 61730-1:2016 pour au moins la tension de module unique ou Voc, et le degré de pollution du module.

4. Module solaire (10) selon l'une quelconque des revendications précédentes, dans lequel la couche intermédiaire stratifiée recouvre sensiblement la totalité des une ou plusieurs cellules solaires sur un côté de face arrière.

5. Module solaire (10) selon l'une quelconque des revendications 2 à 4, dans lequel (ii) s'applique, et dans lequel les un ou plusieurs éléments d'interconnexion électriquement conducteurs (30) s'étendent à travers un espace entre les régions non contiguës de la couche intermédiaire.

6. Module solaire (10) selon l'une quelconque des revendications précédentes, dans lequel les un ou plusieurs éléments d'interconnexion électriquement conducteurs (30) comprennent une barre omnibus d'interconnexion.

7. Module solaire (10) selon l'une quelconque des revendications précédentes, dans lequel la borne est située sur un côté de face arrière du module.

8. Module solaire (10) selon l'une quelconque des revendications précédentes, dans lequel la couche électriquement isolante présente un indice thermique relatif (RTI) supérieur à 90°C.

9. Module solaire selon l'une quelconque des revendications précédentes, dans lequel la couche électriquement isolante (36) comprend un matériau choisi dans le groupe comprenant : polyéthylène téréphtalate (PET), polyoléfines (PO), polyamides (PA) et polycarbonates (PC), facultativement dans lequel la couche électriquement isolante (36) présente une épaisseur de 0,01 mm ou plus.

10. Module solaire (10) selon l'une quelconque des revendications précédentes, dans lequel le film barrière métallique (38) comprend une couche de feuille, facultativement une couche de feuille d'aluminium ou une couche de feuille de cuivre, facultativement le film barrière métallique (38) présente une épaisseur de 5 µm ou plus.

11. Module solaire (10) selon l'une quelconque des revendications précédentes, dans lequel la couche intermédiaire stratifiée comprend une ou plusieurs couches d'apprêt (40a, 40b) disposées sur un côté de face avant et/ou un côté de face arrière de la couche intermédiaire ;
facultativement dans lequel les une ou plusieurs couches d'apprêt (40a, 40b) comprennent un matériau polyoléfinique ;
en outre facultativement dans lequel chacune des une ou plusieurs couches d'apprêt (40a, 40b) comprend un matériau choisi dans le groupe comprenant : éthylène-acétate de vinyle (Eva), polyéthylènes (PE) y compris polyéthylène basse densité linéaire (LLDPE) et élastomères de polyoléfine (POE).

12. Module solaire (10) selon la revendication 11, dans lequel les une ou plusieurs couches d'apprêt (40a, 40b) sont stratifiées sur la couche électriquement isolante (36) et/ou le film barrière métallique (38) via une couche adhésive.

13. Module solaire (10) selon l'une quelconque des revendications précédentes, dans lequel les une ou plusieurs cellules solaires (12) sont des cellules à technologie de hétérojonction (HJT).

14. Procédé de fabrication d'un module solaire (10), le procédé incluant les étapes consistant à :
(i) fournir une ou plusieurs cellules solaires (12), lesdites cellules solaires étant électriquement connectées à une borne via un ou plusieurs éléments d'interconnexion électriquement conducteurs (30) ;
(ii) agencer un agent d'encapsulation (20a, 20b) pour entourer les une ou plusieurs cellules solaires ;
(iii) agencer une feuille arrière (24b) pour recouvrir les une ou plusieurs cellules solaires et l'agent d'encapsulation sur un côté de face arrière du module ; et
(iv) agencer une couche intermédiaire stratifiée (14a, 14b) présentant une étendue latérale inférieure à l'étendue latérale de la feuille arrière (24b) à interposer entre l'agent d'encapsulation et la feuille arrière du module solaire, dans lequel la couche intermédiaire stratifiée (14a, 14b) comprend une couche électriquement isolante (36) et un film barrière métallique (38) agencés dans cet ordre à partir d'un côté de face avant du module vers le côté de face arrière du module ; et
**caractérisé en ce que** la couche intermédiaire stratifiée (14a, 14b) comprend deux régions non contiguës ou plus.

15. Procédé selon la revendication 14, dans lequel l'étape (iv) d'agencement d'une couche intermédiaire stratifiée (14a, 14b) à interposer entre l'agent d'encapsulation et la feuille arrière du module solaire est effectuée entre les étapes (ii) d'agencement d'un agent d'encapsulation (20a, 20b) pour entourer les une ou plusieurs cellules solaires, et (iii) d'agencement d'une feuille arrière (24b) pour recouvrir les une ou plusieurs cellules solaires et l'agent d'encapsulation sur un côté de face arrière du module, facultativement dans lequel la couche intermédiaire stratifiée (14a, 14b) est fixée à la feuille arrière (24b) avant que la feuille arrière ne soit agencée pour recouvrir les une ou plusieurs cellules solaires (12) et l'agent d'encapsulation sur un côté de face arrière du module, et dans lequel les étapes (iii) et (iv) sont effectuées en tant qu'étape de procédé unique d'agencement d'une combinaison couche intermédiaire-feuille arrière pour recouvrir les une ou plusieurs cellules solaires (12) et l'agent d'encapsulation sur un côté de face arrière du module.
